# EUROPÄISCHE PATENTSCHRIFT

(11) **EP 2 193 382 B1**
(45) Veröffentlichungstag und Bekanntmachung des Hinweises auf die Patenterteilung: **23.03.2011**
(21) Anmeldenummer: 09734358.6
(22) Anmeldetag: 09.04.2009
(51) Int. Cl.: G01R 31/28

(54) **PLUNGER MIT SCHNELLVERRIEGELUNGSSYSTEM**
PLUNGER WITH A QUICK LOCKING SYSTEM
ÉLÉMENT PLONGEUR À SYSTÈME DE VERROUILLAGE RAPIDE

(30) Priorität: 24.04.2008 DE 102008020585
(43) Veröffentlichungstag der Anmeldung: 09.06.2010
(73) Patentinhaber: Multitest elektronische Systeme GmbH, 83026 Rosenheim (DE)
(72) Erfinder: MURNAUER, Simon, 83104 Tuntenhausen (DE)
(74) Vertreter: Dilg, Haeusler, Schindelmann Patentanwaltsgesellschaft mbH
(86) Internationale Anmeldenummer: PCT/EP2009/002658
(87) Internationale Veröffentlichungsnummer: WO 2009/129935

(56) Entgegenhaltungen:
- US-A- 5 523 678

## Beschreibung

Die Erfindung betrifft einen Plunger zum Zuführen und Wegbewegen eines elektronischen Bauelements, insbesondere ICs, zu bzw. von einer mit einer Testvorrichtung verbundenen Kontaktiereinrichtung, mit einem Plungerhalteteil und einem Plungerschiebeteil, gemäß dem Anspruch 1.

Elektronische Bauelemente, wie beispielsweise ICs (Halbleiterbauelemente mit integrierten Schaltungen), werden üblicherweise auf ihre Funktionsfähigkeit hin überprüft, bevor sie beispielsweise auf Leiterplatten montiert oder anderweitig verwendet werden. Die zu testenden Bauelemente werden hierbei von einem üblicherweise als "Handler" bezeichneten Handhabungsautomaten mit Kontaktiereinrichtungen kontaktiert, die insbesondere aus Kontaktsockeln ausgebildet sind und mit einem Testkopf einer Testvorrichtung in elektrischem Kontakt stehen. Nach Beendigung des Testvorgangs werden die Bauelemente mittels des Handlers wieder von den Kontaktiereinrichtungen entfernt und in Abhängigkeit des Testergebnisses sortiert.

Zum Halten und Kontaktieren der Bauelemente weisen Handler üblicherweise Plunger auf, d.h. längs verschiebbare, kolbenartig hin- und herbewegbare Halteeinheiten, welche die Bauelemente insbesondere durch Aufbringen einer Saugkraft mittels Unterdruck (Vakuum) halten können. Die Plunger werden nach dem Aufsetzen der Bauelemente auf den Plungerkopf innerhalb des Handlers in eine Position gebracht, in der sie auf geradlinigem Weg weiter zu den Kontaktiereinrichtungen vorgeschoben werden können, bis die Bauelemente mit den Kontaktiereinrichtungen in Kontakt gelangen. Nach Durchführung der Testvorgänge werden die Bauelemente mittels der Plunger wieder vom Testkopf entfernt und derart positioniert, dass sie über eine Entladestation aus dem Handler entfernt und in Abhängigkeit des Testergebnisses sortiert werden können.

Der Plungerkopf, an dem das zu testende Bauelement mittels Saugkraft gehalten wird, ist üblicherweise lösbar mittels Schrauben am Basiskörper des Plungerschiebeteils befestigt. Hierdurch ist es möglich, bei einem Wechsel des Bauelementtyps lediglich den Plungerkopf durch einen anderen, an den neuen Bauelementtyp angepassten Plungerkopf zu ersetzen, während der übrige Teil des Plungers unverändert bleiben kann. Das Austauschen des Plungerkopfs ist jedoch mit einem nicht unerheblichen Arbeitsaufwand verbunden und häufig nicht in der gewünschten einfachen Weise zu bewerkstelligen.

US 5523 678 offenbart eine Kontaktier vorrichtung zum Transportieren eines IC, welche eine Saugeinheit und eine schwimmende Einrichtung aufweist.

Der Erfindung liegt daher die Aufgabe zugrunde, einen Plunger der eingangs genannten Art zu schaffen, bei dem das Austauschen von Plungerköpfen auf besonders schnelle und einfache Weise möglich ist.

Diese Aufgabe wird erfindungsgemäß durch einen Plunger mit den Merkmalen des Anspruchs 1 gelöst. Vorteilhafte Ausführungsformen der Erfindung sind in den weiteren Ansprüchen beschrieben.

Beim erfindungsgemäß Plunger ist der Plungerkopf am Basiskörper mittels eines Schnellverriegelungssystems befestigbar, das ein erstes, am Basiskörper angeordnetes Verriegelungsmittel und ein zweites, am Plungerkopf angeordnetes Verriegelungsmittel umfasst, wobei die beiden Verriegelungsmittel derart ausgebildet sind, dass sie durch Drehen des Plungerkopfes relativ zum Basiskörper in eine gegenseitig hintergreifende Stellung bringbar sind, in der der Plungerkopf axial mit dem Basiskörper gekoppelt ist.

Beim erfindungsgemäßen Plunger lassen sich die Plungerköpfe auf sehr einfache und schnelle Weise am Basiskörper des Plungerschiebeteils dadurch befestigen, dass der Plungerkopf in einer bestimmten Drehwinkelstellung axial auf den Basiskörper aufgesteckt und anschließend um einen bestimmten Winkelbetrag gedreht wird, wodurch eine axiale Verriegelung bewirkt wird. Das Lösen des Plungerkopfs vom Basiskörper erfolgt durch Drehen des Plungerkopfs in umgekehrter Richtung und axiales Abziehen vom Basiskörper. Dies kann vollkommen werkzeuglos erfolgen.

Gemäß einer besonders vorteilhaften Ausführungsform umfasst das am Basiskörper angeordnete Verriegelungsmittel ein in Richtung des Plungerkopfs vorstehendes Kugelteil, das über seinen Umfang verteilt zumindest zwei Axialnuten und dazwischen liegende Kugelflächenabschnitte aufweist. Das am Plungerkopf angeordnete Verriegelungsmittel weist Klammerelemente auf, die längs der Axialnuten bewegbar und durch Drehen des Plungerkopfs in eine die Kugelflächenabschnitte hintergreifende Stellung bringbar sind. Eine derartige Ausführungsform des Schnellverriegelungssystems ermöglicht nicht nur ein besonders einfaches, schnelles Auswechseln der Plungerköpfe, das innerhalb des Handlers mit einer Hand durchgeführt werden kann, sondern es ermöglicht außerdem, dass beim Aufsetzen des Bauelements auf die Anschlusskontakte der Kontaktiereinrichtung sich das Bauelement zusammen mit dem Plungerkopf in allen Raumrichtungen bewegen kann, so dass sich das Bauelement optimal an die Lage der Kontaktiereinrichtung anpassen kann. Zweckmäßigerweise ist hierbei am Plungerkopf eine Zentriereinrichtung zum Zentrieren des Plungerkopfs relativ zur Kontaktiereinrichtung vorgesehen. Eine derartige Zentriereinrichtung kann beispielsweise aus Zentrierbohrungen oder Zentrieraussparungen am Plungerkopf bestehen, in die Zentrierstifte eingeführt werden, die von den Kontaktiereinrichtungen (Kontaktsockeln) vorstehen. Das Zentrieren des Plungerkopfs und damit des Bauelements relativ zur Kontaktiereinrichtung wird dabei nicht durch eine starre Führung des Plungerschiebeteils behindert, und es kommt zu keinen Verspannungen im Plunger.

Gemäß einer vorteilhaften Ausführungsform enthält das Kugelteil eine Unterdruckleitung, die einerseits mit einer Unterdruckversorgungsleitung des Basiskörpers und andererseits mit mindestens einem Unterdruckkanal des Plungerkopfs in Verbindung steht. Hierdurch kann auf einfache und platzsparende Weise der zum Halten des Bauelements erforderliche Unterdruck zur Auflagefläche des Plungerkopfs geleitet werden.

Gemäß einer besonders vorteilhaften Ausführungsform weist der Basiskörper ein Basisteil und eine Kopplungsplatte auf, die quer zur Axialrichtung des Plungers schwimmend am Basisteil gehaltert ist, wobei das erste Verriegelungsmittel auf der Kopplungsplatte befestigt und der Plungerkopf mittels des Schnellverriegelungssystems mit der Kopplungsplatte koppelbar ist. Die schwimmend gehalterte Kopplungsplatte ermöglicht es, das sich der Plungerkopf auch seitlich, d.h. quer zur Längsachse des Plungers, in gewissem Umfang bewegen kann, wenn das Bauelement auf die Kontaktiereinrichtung aufgesetzt wird. Das Zentrieren des Bauelements relativ zur Kontaktiereinrichtung ist damit auf besonders leichtgängige und verspannungsfreie Weise möglich.

Die Erfindung wird nachfolgend anhand der Zeichnungen beispielhaft näher erläutert. Es zeigen:
- Figur 1 :: eine perspektivische Darstellung des erfindungsgemäßen Plungers mit zurückgezogenem Plungerschiebeteil,
- Figur 2 :: den Plunger von Figur 1 mit vorgeschobenem Plungerschiebeteil,
- Figur 3 :: eine Darstellung gemäß Figur 1, wobei der Plunger im Bereich des Plungerkopfs und der Kopplungsplatte geschnitten dargestellt ist,
- Figur 4 :: eine Darstellung gemäß Figur 2, wobei der Plunger im Bereich des Plungerkopfs und der Kopplungsplatte geschnitten darge-stellt ist,
- Figur 5 :: eine perspektivische Darstellung des Piungerkopfs und des ersten, kugelförmigen Verriegelungsmittels in einer Stellung, in welcher der Plungerkopf relativ zum ersten Verriegelungsmittel axial verschiebbar ist,
- Figur 6 :: eine Darstellung des Plungerkopfs und des ersten Verriegelungsmittels in einer Stellung, in welcher der Plungerkopf relativ zum ersten Verriegelungsmittel axial verriegelt ist,
- Figur 7 :: eine Schnittdarstellung durch den Plungerkopf und das erste Verriegelungsmittel von Figur 6, und
- Figur 8 :: eine Draufsicht auf den Plunger ohne Plungerkopf, d.h. auf die Kopplungsplatte.

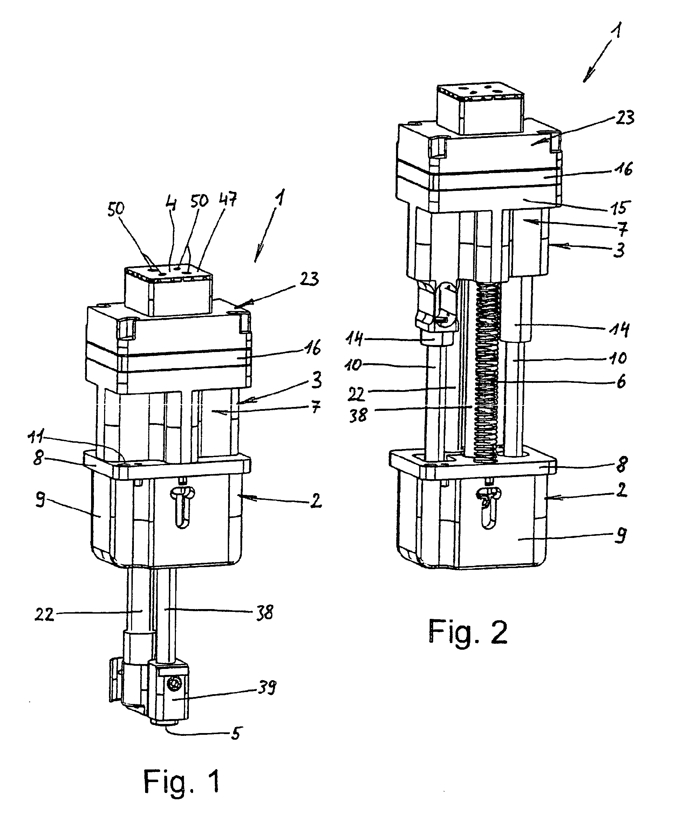

Der in den Figuren 1 bis 4 dargestellte Plunger 1 umfasst im Wesentlichen ein Plungerhalteteil 2 und ein Plungerschiebeteil 3, das längsverschiebbar am Plungerhalteteil 2 gehaltert ist.

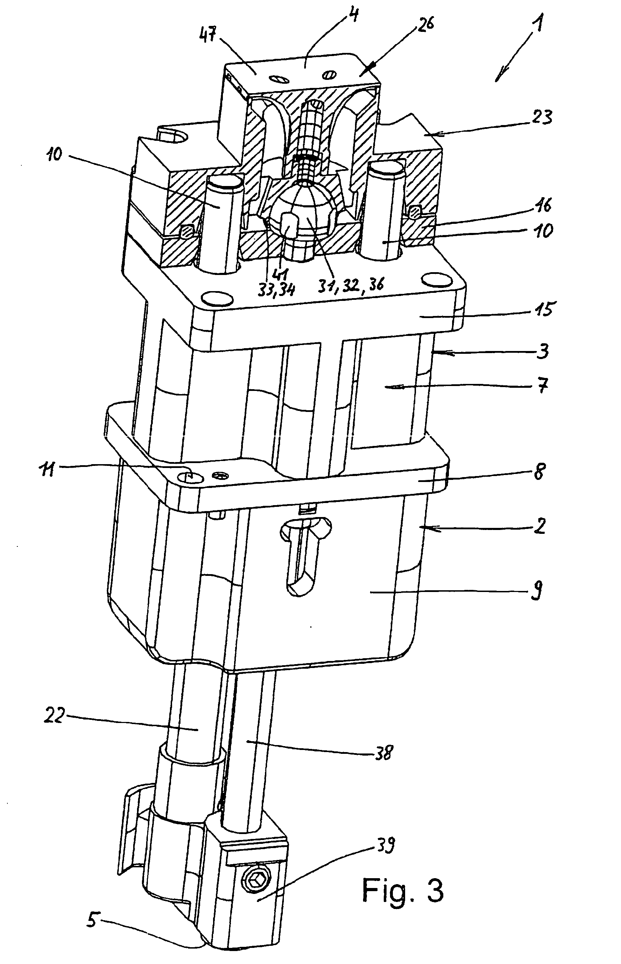

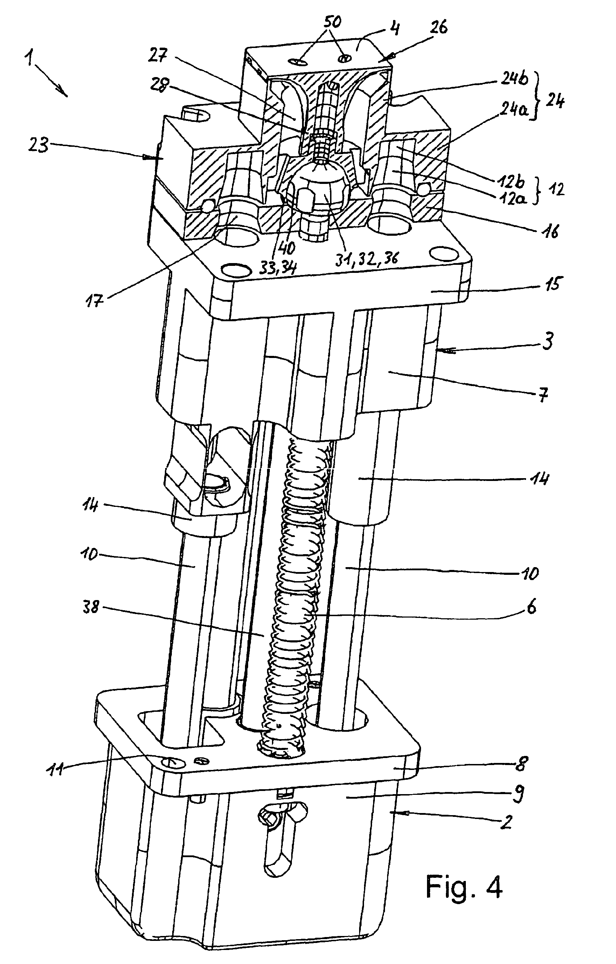

Mittels des Plungerhalteteils 2 kann der Plunger 1 innerhalb eines Handlers an einer nicht dargestellten Schwenkeinrichtung oder an einem Umlaufwagen befestigt sein. Ein nicht dargestelltes elektronisches Bauelement, das auf eine vordere Auflagefläche 4 des Plungerschiebeteils 3 aufgesetzt und dort mittels Unterdruck (Vakuum) gehalten wird, kann damit in eine Position gebracht werden, in welcher das Plungerschiebeteil 3 geradlinig in eine Kontaktposition vorgeschoben werden kann, in der Anschlussbeinchen oder Anschlusskontakte des Bauelements auf entsprechende, nicht dargestellte Anschlusskontakte eines Kontaktsockels aufgesetzt werden. Die Vorwärtsbewegung erfolgt dabei mittels einer nicht dargestellten Vorschubeinrichtung, welche auf eine hintere Stirnfläche 5 des Plungerschiebeteils 3 drückt und dieses relativ zum Plungerhalteteil 2 nach vorne schiebt, wie aus Figur 2 und 4 ersichtlich. Das Zurückführen des Plungers 1 in seine in den Figuren 1 und 3 dargestellte Ausgangslage erfolgt über eine Rückholfeder 6 in der Form einer Zugfeder, die mit ihrem hinteren Ende am Plungerhalteteil 2 und mit ihrem vorderen Ende an einem Basiskörper 7 des Plungerschiebeteils 3 befestigt ist.

Das Plungerhalteteil 2 weist eine Halteplatte 8, einen Haltekörper 9 und zwei Zentrierstifte 10 auf. Die Halteplatte 8 steht seitlich flanschartig über den Haltekörper 9 vor und weist in zwei diagonal gegenüberliegenden Eckenbereichen Bohrungen 11 zur Aufnahme nicht dargestellter Schrauben auf, mit denen die Halteplatte 8 an der nicht dargestellten Schwenkeinrichtung oder einem Umlaufwagen festgeschraubt werden kann.

Der Haltekörper 9 ist auf der hinteren Seite der Halteplatte 8 angeordnet und einstückig an diese angeformt. Die beiden Zentrierstifte 10 sind parallel zueinander angeordnet und an ihrem hinteren Ende im Bereich der hinteren Stirnwand des Haltekörpers 9 befestigt. Weiterhin stehen die Zentrierstifte 10 ein beträchtliches Maß über die Halteplatte 8 hinaus nach vorn vor. Die Länge der Zentrierstifte ist so bemessen, dass sie sich im zurückgezogenen Zustand des Plungerschiebeteils 3, wie aus Figur 3 ersichtlich, durch den gesamten Basiskörper 7 hindurch bis in Zentrierbohrungen 12 eines lösbar am Basiskörper 7 befestigten Plungerkopfs 23 hinein erstrecken. Im vorgeschobenen Zustand des Plungerschiebeteils 3, der in den Figuren 3 und 4 dargestellt ist, gelangen die Zentrierstifte 10 außer Eingriff mit den Zentrierbohrungen 12, so dass sich der Plungerkopf 13 relativ zum Basiskörper 7 drehen und nach allen Richtungen geringfügig kippen lässt, wie später noch näher beschrieben wird. In diesem vorgeschobenen Zustand des Plungerschiebeteils 3 befinden sich die Zentrierstifte 10 jedoch immer noch in Eingriff mit Führungshülsen 14, die am hinteren Ende des Basiskörpers 7 angeordnet sind. Im zurückgezogenen Zustand des Plungerschiebeteils 3 befinden sich die Führungshülsen 14 innerhalb des Plungerhalteteils 2, so dass sie in den Figuren 1 und 3 nicht sichtbar sind.

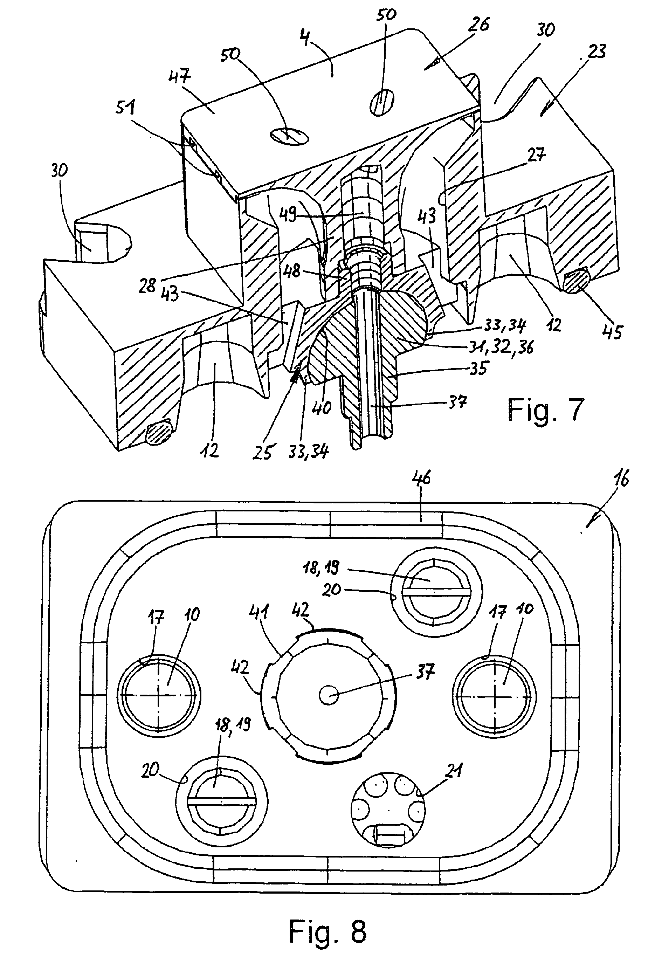

Der Basiskörper 7 besteht aus einem hinteren Basisteil 15, an dessen rückseitigem Ende die Führungshülsen angeformt sind, und einer vorderen Zwischen- oder Kopplungsplatte 16, die seitlich schwimmend am Basisteil 15 gehaltert ist.
Aufgrund dieser schwimmenden Halterung kann die Kopplungsplatte 16 relativ zum Basisteil 15 in einer Ebene, die senkrecht zur Längsrichtung des Plungers 1 liegt, in einem bestimmten Umfang bewegt werden. Dies wird dadurch erreicht, dass, wie aus Figur 8 ersichtlich, Bohrungen 17 der Kopplungsplatte 16, durch welche die Zentrierstifte 10 im zurückgezogenen Zustand des Plungerschiebeteils 3 hindurchragen, einen Durchmesser aufweisen, der um ein bestimmtes Maß größer ist als der Außendurchmesser der Zentrierstifte 10. Die Zentrierstifte 10 haben somit innerhalb der Bohrungen 17 seitliches Spiel.

Die axiale Festlegung der Kopplungsplatte 16 am Basisteil 15 erfolgt mittels zweier Schrauben 18, von denen in Figur 8 nur die Schraubenköpfe 19 sichtbar sind. Die Schraubenschäfte der Schrauben 18 durchdringen Bohrungen der Kopplungsplatte 16, die wiederum einen größeren Durchmesser als der Außendurchmesser der Schraubenschäfte haben. Weiterhin liegen die Schraubenköpfe 19 in Senkbohrungen 20, deren Durchmesser größer als der Außendurchmesser der Schraubenköpfe 19 ist. Die Schraubenköpfe 19, die im Bereich der Senkbohrungen 20 die Kopplungsplatte 16 übergreifen, halten die Kopplungsplatte 16 mit geringem axialen Spiel, jedoch seitlich beweglich, an der Kopplungsplatte 16.

Die Kopplungsplatte 16 weist weiterhin, wie aus Figur 8 ersichtlich, eine Axialbohrung 21 auf, um temperiertes Fluid, insbesondere ein temperiertes Gas, durch die Kopplungsplatte 16 hindurchführen zu können. Ein derartiges temperiertes Fluid dient zum Abkühlen oder Erwärmen der am Plunger 1 festgesaugten Bauelemente, falls die Bauelemente unter bestimmten Temperaturbedingungen getestet werden sollen. Die Axialbohrung 21 fluchtet hierzu mit einer weiteren, nicht näher dargestellten Axialbohrung des Basisteils 15, die mit einer Fluidzufuhrleitung 22 (Figuren 1 bis 4) des Plungerschiebeteils 3 in Verbindung steht. Die Fluidzufuhrleitung 22 durchdringt eine entsprechende Ausnehmung im Plungerhalteteil 2 und erstreckt sich in der zurückgezogenen Stellung des Plungerschiebeteils 3 nach hinten über das Plungerhalteteil hinaus.

Der Plunger 1 weist weiterhin einen Plungerkopf 23 auf, der auf der Kopplungsplatte 16 mittels eines speziellen, später noch näher beschriebenen Schnellverriegelungssystems befestigbar ist. Der Plungerkopf 23 weist im Wesentlichen einen Sockel 24, ein Kopfzentralteil 25 und einen Temperierkörper 26 auf. Das Kopfzentralteil 25 ist fest mit dem Sockel 24 verbunden oder einstückig mmit diesem ausgebildet.

Der Sockel 24 besteht aus einem hinteren, quaderförmigen Sockelabschnitt 24a und einem vorderen Sockelabschnitt 24b mit verringertem Außendurchmesser. Eine zentrale, axial durchgehende Aussparung 27 im Sockel 24 ist so bemessen, dass im hinteren Endbereich des Sockels 24 das Kopfzentralteil 25 und von vorne her ein hülsenförmiger Schaftabschnitt 28 des Temperierkörpers 26 eingesetzt werden können.

Im hinteren Sockelabschnitt 24a sind die zwei Zentrierbohrungen 12 in der Form von Sacklochbohrungen vorgesehen, die im fertig montierten Zustand des Plungerkopfs 23 mit den Bohrungen 17 der Kopplungsplatte 16 fluchten. Der hintere Abschnitt 12a der Zentrierbohrungen 12 erweitert sich nach hinten konusförmig, um eine Einführschräge für die Zentrierstifte 10 zu bilden. Der Durchmesser des vorderen Abschnitts 12b der Zentrierbohrungen 12 ist dagegen so bemessen, dass die Zentrierstifte 10 mit nur geringem radialen Spiel aufgenommen werden können, wenn das Plungerschiebeteil 3 in die äußerste zurückgezogene Endstellung zurückbewegt wird. In der zurückgezogenen Endstellung ist der Plungerkopf 23 somit durch die Zentrierstifte 10 relativ zum Basiskörper 7 und damit auch relativ zum Plungerhalteteil 2 zentriert. Aufgrund dieser "Rückzentrierung" wird der Plungerkopf 23 wieder in eine definierte Ausgangslage zurückgebracht und gleichzeitig seitlich verriegelt, so dass sich der Plungerkopf nicht mehr in ungewollter Weise seitlich verschieben kann, wenn der Plunger in seiner zurückgezogenen Position innerhalb des Handlers schnell bewegt wird. Wird dagegen das Plungerschiebeteil 3 zusammen mit dem angesaugten Bauelement nach vorne in Richtung des Kontaktsockels bewegt, gelangen die Zentrierstifte 10 außer Eingriff mit den Zentrierbohrungen 29, so dass der Plungerkopf 23 zusammen mit der Kopplungsplatte 16 seitlich in gewissem Umfang bewegt werden und auch relativ zur Kopplungsplatte 16 nach allen Seiten hin etwas kippen kann, wie später noch näher beschrieben wird. Das Aufheben der starren Kopplung zwischen Plungerkopf 23 und dem Basiskörper 7 ermöglicht es, dass der Plungerkopf 23 kurz bevor er die auf Seiten der Testvorrichtung angeordnete Kontaktiereinrichtung, z.B. einen Kontaktsockel, erreicht, verspannungsfrei von anderen Zentriermitteln zentriert wird, die im Bereich dieser Kontaktiereinrichtung angeordnet sind. Hierzu weist der hintere Sockelabschnitt 24a in den Eckenbereichen Zentrieraussparungen 30 auf, die mit den nicht dargestellten, im Bereich der Kontaktiereinrichtung angeordneten Zentrierstiften in Eingriff gelangen, wenn das Bauelement auf die Kontaktiereinrichtung aufgesetzt wird.

Um den Plungerkopf 23 an der Kopplungsplatte 16 festzulegen, ist an der Kopplungsplatte 16 ein erstes Verriegelungsmittel 31 in der Form eines Kugelteils 32 befestigt, das mit einem zweiten Verriegelungsmittel in der Form von vier Klammerelementen 34 zusammenwirkt, die am Kopfzentralteil 25 angeordnet sind.

Das Kugelteil 32 ist mittig auf der Kopplungsplatte 16 befestigt und weist einen in eine zentrale Gewindebohrung der Kopplungsplatte 16 einschraubbaren Schaftabschnitt 35 und einen nach vorn über die Kopplungsplatte 16 hinausragenden Kugelkopf 36 auf. Das Kugelteil 32 ist mit einer mittigen, durchgehenden Unterdruckleitung 37 versehen, die an ihrem hinteren Ende mit einer als Unterdruckrohr ausgebildeten Unterdruckversorgungsleitung 38 des Plungerschiebeteils 3 (Figur 3) in Verbindung steht. Das Unterdruckrohr 38 ist am Basiskörper 7 befestigt und erstreckt sich zwischen den Zentrierstiften 10 und parallel zu diesen durch das Plungerhalteteil 2 hindurch nach hinten bis zu einem Plungerversorgungsteil 39. Dieses Plungerversorgungsteil 39 weist einen nicht näher dargestellten Anschluss zur Verbindung des Unterdruckrohrs 38 mit einer Unterdruckerzeugungseinrichtung auf. Weiterhin endet auch die Fluidzufuhrleitung 22 im Plungerversorgungsteil 39, so dass über das Plungerversorgungsteil 39 Fluid in die Fluidzufuhrleitung 22 eingeleitet werden kann. Soll das Fluid erwärmt werden, kann sich in der Fluidzufuhrleitung 22 auch eine Heizeinrichtung, beispielsweise in der Form einer elektrischen Widerstandsheizung, die spiralförmig gewinkelt ist, befinden.

Das Unterdruckrohr 38, das in einer Führungsbohrung der Halteplatte 8 geführt ist, dient neben den beiden Zentrierstiften 10 als weiteres Führungselement zur Führung des Plungerschiebeteils 3 am Plungerhalteteil 2.

Der Schaftabschnitt 35 des Kugelteils 32 ist ferner mit dem Unterdruckrohr 38 beweglich verbunden, so dass sich das Kugelteil 32 zusammen mit der Kopplungsplatte 16 relativ zum Basisteil 15 seitlich bewegen kann.

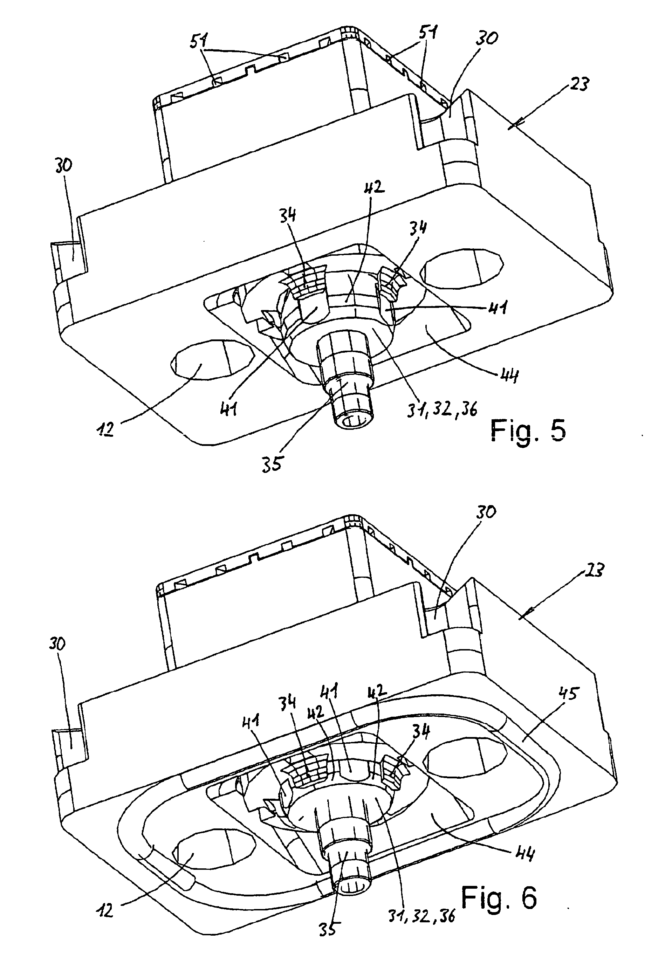

Auf den Kugelkopf 36 kann eine Kugelkalotte 40 aufgesetzt werden, die Teil des Kopfzentralteils 25 ist. Figur 7 zeigt einen Zustand, in dem die Kugelkalotte 40 auf dem Kugelkopf 36 aufliegt. Wie aus den Figuren 5 bis 7 ersichtlich, bestehen die Klammerelemente 34 aus fingerartigen Vorsprüngen, die nach hinten über die Kugelkalotte 40 vorstehen, wobei die Innenflächen der Klammerelemente 34, wie aus der Schnittdarstellung von Figur 7 ersichtlich, die Wölbung der Kugelkalotte 40 bis zu ihrem freien Ende kontinuierlich fortführen. Die Klammerelemente 34 erstrecken sich dabei so weit um den Kugelkopf 36 herum, dass der lichte Abstand zwischen zwei gegenüberliegenden Klammerelementen 34 im Bereich ihrer freien Enden geringer ist als in ihren Übergangsbereichen zur Kugelkalotte 40. Hierdurch kann in der Position, die in den Figuren 6 und 7 dargestellt ist, der Plungerkopf 23 nicht mehr vom Kugelkopf 36 axial abgehoben werden. Andererseits wird hierdurch eine Kugelkopfhalterung geschaffen, die es grundsätzlich ermöglicht, den Plungerkopf 23 nach allen Seiten hin zu schwenken bzw. zu kippen und um die Längsachse des Plungers 1 zu drehen.

Damit der Plungerkopf 23 in die in den Figuren 6 und 7 dargestellte Verriegelungsstellung gebracht werden kann, weist der Kugelkopf 36 vier regelmäßig über seinen Umfang verteilte Axialnuten bzw. Abflachungen 41 auf, die insbesondere aus den Figuren 5 und 6 ersichtlich sind. Der Abstand zwischen zwei gegenüberliegenden Axialnuten 41 ist dabei geringfügig kleiner als der kleinste Abstand zwischen zwei gegenüberliegenden Klammerelementen 34. Auf diese Weise ist es möglich, dass die Klammerelemente 34 längs der Axialnuten 41 verschoben werden, wenn sich die Klammerelemente 34 im Bereich der Axialnuten 41 befinden. Diese Situation ist in Figur 5 dargestellt. Der Plungerkopf 23 befindet sich dabei relativ zur Kopplungsplatte 16 in einer Drehstellung, die nicht der Betriebsstellung entspricht. Am hinteren Ende der Axialnuten 41 wölbt sich dagegen die Kugelfläche des Kugelkopfs 36 soweit nach innen, dass sich der Plungerkopf 23 zusammen mit den Klammerelementen 34 relativ zur Kopplungsplatte 16 drehen lässt, wobei die Klammerelemente 34 aus dem Bereich der Axialnuten 41 in den Bereich der dazwischen liegenden Kugelflächenabschnitte 42 gelangen und den Kugelkopf 36 hintergreifen. In dieser Stellung, die in Figur 6 dargestellt ist, ist der Plungerkopf 23 axial mit dem Kugelkopf 36 verriegelt.

Wie aus Figur 7 ersichtlich, weist das Kopfzentralteil 25 weiterhin regelmäßig über seinen Außenumfang verteilte Fluidkanäle 43 auf. Durch diese Fluidkanäle 43 wird temperiertes Fluid, das über die Fluidzufuhrleitung 22 und die Axialbohrung 21 der Kopplungsplatte 16 zugeführt wird, vom hinteren Sockelabschnitt 24a zum vorderen Sockelabschnitt 24b geleitet, um dort auf den Temperierkörper 26 zu treffen und diesen entsprechend zu temperieren. Damit das aus der Axialbohrung 21 der Kopplungsplatte 16 austretende Fluid gleichmäßig auf alle Fluidkanäle 43 des Kopfzentraiteiis 25 verteilt wird, weist der Sockel 24 an seiner hinteren Stirnfläche eine taschenartige Aussparung 44 auf (Figuren 5, 6) in welche die Fluidkanäle 43 münden.

Zur fluiddichten Abdichtung zwischen dem Plungerkopf 23 und der Kopplungsplatte 16 ist eine umlaufende Dichtung 45 in der Form eines O-Rings vorgesehen, die in eine entsprechende umlaufende Nut des Plungerkopfs 23 eingebettet ist. Diese Dichtung 45 umschließt die Zentrierbohrungen 12 und die taschenartige Aussparung 44 des Sockels 24 vollständig. Weiterhin ist auch, wie aus Figur 8 ersichtlich, auf der Vorderseite der Kopplungsplatte 16 eine umlaufende Nut 46 vorgesehen, in der die Dichtung 45 zu liegen kommt, wenn der Plungerkopf 23 auf der Kopplungsplatte 16 aufgesetzt ist. Die Dichtung 45 ist so weich ausgebildet, dass sie ein Kippen des Plungerkopfs 23 um den Kugelkopf 36 herum in gewissem Maß zulässt.

Der Temperierkörper 26 ist im Querschnitt, wie aus Figur 7 ersichtlich, im Wesentlichen T-förmig ausgebildet und besteht aus dem sich in Axialrichtung erstreckenden Schaftabschnitt 28 und einer quer zur Axialrichtung angeordneten Auflageplatte 47, auf welche das zu testende Bauelement aufgesetzt und mittels Unterdruck gehalten wird. Der Temperierkörper 26, der zweckmäßigerweise aus einem gut wärmeleitfähigen Material, insbesondere Metall wie Aluminium, besteht, dient somit nicht nur zur Temperierung der Bauelemente, sondern ist gleichzeitig ein Teil des Unterdrucksystems, mit dem Unterdruck an der Auflagefläche 4 bereit gestellt wird. Hierzu ist der Schaftabschnitt 28 des Temperierkörpers 26 mit einem vorderen Rohrstutzen 48 des Kopfzentralteils 25 verbunden und weist einen zentralen Kanal 49 auf, der über den Rohrstutzen 48 mit der Unterdruckleitung 37 des Kugelteils 32 verbunden ist. Vom vorderen Ende des zentralen Kanals 49 erstrecken sich eine Mehrzahl von Unterdruckkanälen 50 zur Auflagefläche 4, die an unterschiedlichen Stellen in die Auflagefläche 4 münden. Hierdurch wird das Bauelement an unterschiedlichen Stellen festgesaugt, was eine sehr sichere Halterung des Bauelements am Plungerkopf 23 gewährleistet.

Die Auflagefläche 4 des Temperierkörpers 26 ist eben und so bemessen, dass der Körper der zu testenden Bauelemente vollflächig aufliegen kann.

Der Außendurchmesser des Schaftabschnitts 28 des Temperierkörpers 26 ist zweckmäßigerweise wesentlich geringer als die lichte Weite der axialen Aussparung 27 des Plungerkopfs 23, so dass das temperierte Fluid von allen Seiten her von den Fluidkanälen 43 zum Temperierkörper 26 strömen kann. Um die Temperierung des Temperierkörpers 26 zu verbessern, kann dieser mit auf der Anströmseite angeordneten, oberflächenvergrößernden Rippen versehen sein. Über seitliche Aussparungen 51 in der Auflageplatte 47 kann das temperierte Fluid aus der axialen Aussparung 27 seitlich nach außen abströmen.

Im Rahmen der Erfindung sind eine Vielzahl von Variationen möglich. Beispielsweise ist es nicht unbedingt erforderlich, dass eine schwimmende Kopplungsplatte 16 vorgesehen ist. Das Schnellverriegelungssystem könnte auch direkt zwischen dem Plungerkopf 23 und dem Basisteil 15 realisiert werden. Weiterhin ist es nicht unbedingt erforderlich, dass die Auflageplatte 47 des Temperierkörpers 26 den vorderen Sockelabschnitt 24b überdeckt, wie in den Zeichnungen dargestellt. Der Temperierkörper 26 könnte vielmehr auch vollständig innerhalb der axialen Aussparung 27 des Sockels 24 angeordnet sein. Weiterhin wäre es in diesem Fall auch möglich, die Auflagefläche 4 für das Bauelement so anzuordnen, dass die Wände des vorderen Sockelabschnitts 24b als Auflager für Anschlussbeinchen der Bauelemente dienen. Obwohl es besonders vorteilhaft ist, als zweites Verriegelungsmittel 33 vier Klammerelemente 34 zu verwenden, ist es ohne weiteres möglich, eine hiervon abweichende Anzahl von Klammerelementen 34, jedoch mindestens zwei Klammerelemente 34, vorzugsweise zwischen zwei und acht Klammerelementen, vorzusehen.

## Patentansprüche

1. Plunger zum Zuführen und Wegbewegen eines elektronischen Bauelements, insbesondere ICs, zu bzw. von einer mit einer Testvorrichtung verbundenen Kontaktiereinrichtung, mit
- einem Plungerhalteteil (2),
- einem Plungerschiebeteil (3), das verschiebbar am Plungerhalteteil (2) geführt ist und einen Basiskörper (7) und einen am Basiskörper (7) befestigbaren Plungerkopf (23) zum Halten des elektronischen Bauelements mittels Unterdruck aufweist,
wobei der Plungerkopf (23) am Basiskörper (7) mittels eines Schnellverriegelungssystems befestigbar ist, das ein erstes, am Basiskörper (7) angeordnetes Verriegelungsmittel (31) und ein zweites, am Plungerkopf (23) angeordnetes Verriegelungsmittel (33) umfasst, wobei die beiden Verriegelungsmittel (31, 33) derart ausgebildet sind, dass sie durch Drehen des Plungerkopfs (23) relativ zum Basiskörper (7) in eine gegenseitig hintergreifende Stellung bringbar sind, in der der Plungerkopf (23) axial mit dem Basiskörper (7) gekoppelt ist,
wobei das am Basiskörper (7) angeordnete Verriegelungsmittel (31) ein in Richtung des Plungerkopfs (23) vorstehendes Kugelteil (32) umfasst, das über seinen Umfang verteilt zumindest zwei Axialnuten (41) und dazwischen liegende Kugelflächenabschnitte (42) aufweist, und dass das am Plungerkopf (23) angeordnete Verriegelungsmittel (33) Klammerelemente (34) aufweist, die längs der Axialnuten (41) bewegbar und durch Drehen des Plungerkopfs (23) in eine die Kugelflächenabschnitte (42) hintergreifende Stellung bringbar sind und
wobei das Kugelteil (32) eine Unterdruckleitung (37) enthält, die einerseits mit einer Unterdruckversorgungsleitung (38) des Basiskörpers (7) und andererseits mit mindestens einem Unterdruckkanal (50) des Plungerkopfs (23) in Verbindung steht.

2. Plunger nach Anspruch 1, wobei der Plungerkopf (23) ein Kopfzentralteil (25) mit einer an das Kugelteil (32) des Basiskörpers (7) angepassten Kugelkalotte (40) aufweist, die auf das Kugelteil (32) aufsetzbar ist.

3. Plunger nach einem der Ansprüche 1 oder 2, wobei der Basiskörper (7) ein Basisteil (15) und eine Kopplungsplatte (16) aufweist, die quer zur Axialrichtung des Plungers (1) schwimmend am Basisteil (15) gehaltert ist, wobei das erste Verriegelungsmittel (31) auf der Kopplungsplatte (16) befestigt und der Plungerkopf (23) mittels des Schnellverriegelungssystems mit der Kopplungsplatte (16) koppelbar ist.

4. Plunger nach einem der Ansprüche 1 bis 3, wobei der Plungerkopf (23) mindestens eine axiale Zentrierbohrung (12) aufweist und am Plungerhalteteil (2) mindestens ein in Richtung des Plungerkopfs (23) vorstehender Zentrierstift (10) befestigt ist, der in der zurückgezogenen Position des Plungerschiebeteils (3) in die zugeordnete Zentrierbohrung (12) des Plungerkopfs (23) eingreift und in der vorgeschobenen Position des Plungerschiebeteils (3) außer Zentriereingriff mit dem Plungerkopf (23) ist.

5. Plunger nach einem der Ansprüche 1 bis 4, wobei der Plungerkopf (23) einen Sockel (24) mit einem vorderen Sockelabschnitt (24b) und einem in den vorderen Sockelabschnitt (24b) einsetzbaren und/oder auf diesen aufsetzbaren, gut wärmeleitfähigen Temperierkörper (26) mit einer Auflagefläche (4) für das elektronische Bauelement aufweist, wobei mindestens ein Unterdruckkanal (50) durch den Temperierkörper (26) hindurch verläuft und in die Auflagefläche (4) mündet.

6. Plunger nach Anspruch 5, wobei um die Kugelkalotte (40) des Kopfzentralteils (25) herum eine Mehrzahl von Fluidkanälen (43) angeordnet sind, die zum vorderen Sockelabschnitt (24b) führen und temperiertes Fluid zum Temperierkörper (26) leiten.

7. Plunger nach Anspruch 6, wobei der Plungerkopf (23) auf seiner der Kopplungsplatte (16) zugewandten Seite eine umlaufende Dichtung (45) aufweist, die sich um die Fiuidkanäle (43) herum erstreckt und an der Kopplungsplatte (16) fluiddicht anliegt.

## Claims

1. Plunger for feeding and removing an electronic component, in particular ICs, to and from a contacting device, respectively which is connected to a testing device, comprising:
a plunger support part (2);
a plunger slide part (3) which is guided at the plunger support part (2) in a slidably manner and which comprises a base body (7) and a plunger head (28) connectable to the base body (7) for holding the electronic component by low pressure,
wherein the plunger head (23) is connectable to the base body (7) by a quick acting lock system comprising a first locking means (31) arranged at the base body (7) and a second locking means (33) arranged at the plunger head (23), wherein the both locking means are designed in such a way that they can be brought into a position, in which the they mutually engage behind, by rotating the plunger head (23) relative to the base body (7), in which position the plunger head (23) is axially coupled to the base body (7),
wherein the locking means (31) arranged at the base body (7) comprises a spherical part (32) which projects into the direction of the plunger head (23) and which has at least two axially grooves (41) distributed across its periphery and spherical surface portions (42) arranged therebetween, while the locking means (33) which is arranged at the plunger head (23) comprises clamping elements (34) which are moveable along the axially grooves (41) and which can be, by rotating the plunger head, brought in a position in which they engage behind the spherical surface portions, and
wherein the spherical part (32) comprises a low pressure duct (37) which is on the one hand connected to a low pressure supply duct (38) of the base body (7) while on the other hand is connected to at least one low pressure duct (50) of the plunger head (23).

2. Plunger according to claim 1,
wherein the plunger head (23) comprises a central head part (25) having a spherical calotte adapted to the spherical part (32) of the base body (7), which calotte is attachable onto the spherical part (32).

3. Plunger according to claim 1 or 2,
wherein the base body (7) comprises a base part (15) and a coupling plate (16) which is floatingly mounted at the base part (15) transversally to the axial direction of the plunger (1), wherein the first locking means (31) is fixed on the coupling plate (16) and the plunger head (23) is couplable to the coupling plate (16) by the quick acting lock system.

4. Plunger according to any one of the claims 1 to 3,
wherein the plunger head (23) comprises at least one axially centering bore (12) and at least one centering pin (10) is fixed to the plunger support part (2), which pin is projecting into the direction of the plunger head (23), which, in its pulled back position, engages with the associated centering bore (12) of the plunger head (23), and which is not in centering engagement with the plunger head (23) when the plunger slide part (3) is in the advanced position.

5. Plunger according to any one of the claims 1 to 4,
wherein the plunger head (23) comprises a socket (24) comprising a front socket section (24b) and a tempering body (26) which is insertable into and/or attachable onto the socket section (24), which tempering body has a good thermal conduction and having a support surface (4) for the electronic component, wherein at least one low pressure channel (50) runs through the tempering body (26) and ends in the support surface (4).

6. Plunger according to claim 5,
wherein a plurality of fluid channels (43) are arranged around the spherical calotte (40) of the central head part (25), which lead to the front socket section (24b) and which guide tempered fluid to the tempering body (26).

7. Plunger according to claim 6,
wherein the plunger head (23) comprises a circumferential sealing (45) on its side which faces the coupling plate (16), which sealing extends around the fluid channels (43) and fits fluid tight to the coupling plate (16).

## Revendications

1. Piston plongeur pour l'amenée et l'éloignement d'un élément structurel électronique, en particulier des circuits intégrés, à ou d'un dispositif d'établissement de contact relié à un dispositif test, avec
- une partie de retenue de piston plongeur (2),
- une partie coulissante de piston plongeur (3) qui est guidée de manière mobile sur la partie de retenue de piston plongeur (2) et présente un corps de base (7) et une tête de piston plongeur (23) pouvant être fixée sur le corps de base (7) pour la retenue de l'élément structurel électronique par dépression,
la tête de piston plongeur (23) pouvant être fixée sur le corps de base (7) à l'aide d'un système de verrouillage rapide qui comporte un premier moyen de verrouillage (31) disposé sur le corps de base (7) et un second moyen de verrouillage (33) disposé sur la tête du piston plongeur (23), les deux moyens de verrouillage (31, 33) étant réalisés de manière à pouvoir être amenés par rotation de la tête de piston plongeur (23) par rapport au corps de base (7) dans une position venant en prise par derrière mutuellement, dans laquelle la tête de piston plongeur (23) est couplée axialement au corps de base (7),
le moyen de verrouillage (31) disposé sur le corps de base (7) comportant une partie sphérique (32) saillant en direction de la tête de piston plongeur (23) qui présente au moins deux rainures axiales (41) et des sections de surface sphérique (42) intermédiaires réparties sur sa périphérie et en ce que le moyen de verrouillage (33) disposé sur la tête de piston plongeur (23) présente des éléments d'agrafe (34) qui peuvent être déplacés le long des rainures axiales (41) et amenés par rotation de la tête de piston de plongeur (23) dans une position venant en prise derrière les sections de surface sphérique (42) et
la partie sphérique (32) contenant une conduite à dépression (37) qui est en liaison d'une part avec une conduite d'alimentation en dépression (38) du corps de base (7) et d'autre part avec au moins un canal à dépression (50) de la tête de piston plongeur (23).

2. Piston plongeur selon la revendication 1, la tête de piston plongeur (23) présentant une partie centrale de tête (25) avec une calotte sphérique (40) adaptée à la partie sphérique (32) du corps de base (7) qui peut être placée sur la partie sphérique (32).

3. Piston plongeur selon l'une quelconque des revendications 1 ou 2, le corps de base (7) présentant une partie de base (15) et une plaque d'accouplement (16) qui est maintenue flottante transversalement au sens axial du piston plongeur (1) sur la partie de base (15), le premier moyen de verrouillage (31) étant fixé sur la plaque d'accouplement (16) et la tête de piston plongeur (23) pouvant être couplée à l'aide du système de verrouillage rapide à la plaque d'accouplement (16).

4. Piston plongeur selon l'une quelconque des revendications 1 à 3, la tête de piston plongeur (23) présentant au moins un perçage de centrage axial (12) et sur la partie de retenue de piston plongeur (2) étant fixée au moins une goupille de centrage (10) dépassant en direction de la tête de piston plongeur (23), qui s'engage dans la position rétractée de la partie coulissante du piston plongeur (3) dans le perçage de centrage associé (12) de la tête de piston plongeur (23) et est en désengagement de centrage avec la tête de piston plongeur (23) dans la position avancée de la partie coulissante de piston plongeur (3).

5. Piston plongeur selon l'une quelconque des revendications 1 à 4, la tête de piston plongeur (23) présentant un socle (24) avec une section de socle avant (24b) et un corps tempéré (26) pouvant être inséré dans la section de socle avant (24b) et/ou pouvant être placé sur celle-ci, présentant une bonne conductibilité thermique avec une surface d'appui (4) pour l'élément structurel électronique, au moins un canal à dépression (50) s'étendant au travers du corps tempéré (26) et débouchant dans la surface d'appui (4).

6. Piston plongeur selon la revendication 5, autour de la calotte sphérique (40) de la partie centrale de tête (25) étant disposée une pluralité de canaux fluidiques (43) qui mènent à la section de socle avant (24b) et conduisent le fluide tempéré au corps tempéré (26).

7. Piston plongeur selon la revendication 6, la tête de piston plongeur (23) présentant sur son côté tourné vers la plaque d'accouplement (16), une garniture rotative (45) qui s'étend autour des canaux fluidiques (43) et repose de manière étanche au fluide sur la plaque d'accouplement (16).
